# EUROPEAN PATENT SPECIFICATION

(11) **EP 2 732 071 B1**
(45) Date of publication and mention of the grant of the patent: **03.06.2020**
(21) Application number: 12812080.5
(22) Date of filing: 11.07.2012
(51) Int. Cl.: C23C 16/50, C23C 16/448

(54) **MIXED METAL OXIDE BARRIER FILMS AND ATOMIC LAYER DEPOSITION METHOD FOR MAKING MIXED METAL OXIDE BARRIER FILMS**
MISCHMETALLOXID-BARRIEREFILME UND VERFAHREN ZUR ABSCHEIDUNG VON ATOMSCHICHTEN ZUR HERSTELLUNG VON MISCHMETALLOXID-BARRIEREFILMEN
FILMS BARRIÈRES D'OXYDE MÉTALLIQUE MIXTE ET PROCÉDÉ DE DÉPÔT DE COUCHE ATOMIQUE POUR RÉALISER DES FILMS BARRIÈRES D'OXYDE MÉTALLIQUE MIXTE

(30) Priority: 11.07.2011 US 201161506607 P
(43) Date of publication of application: 21.05.2014
(73) Proprietor: Lotus Applied Technology, LLC, Hillsboro, Oregon 97006-1997 (US)
(72) Inventor: DICKEY, Eric R., Hillsboro, Oregon 97006-1997 (US)
(74) Representative: Bond, Christopher William
(86) International application number: PCT/US2012/046308
(87) International publication number: WO 2013/009913

(56) References cited:
- WO-A2-2008/014492
- KR-A- 20110 074 052
- US-A- 5 262 199
- US-A1- 2009 108 747
- US-A1- 2009 324 971
- US-A1- 2010 143 710
- US-A1- 2010 255 625
- US-B2- 7 976 909

## Description

### Technical Field

The field of the present disclosure relates to mixed metal oxide barrier films and processes for deposition of such barrier films.

### Background

Gases, liquids, and other environmental factors may cause deterioration of various goods, such as food, medical devices, pharmaceutical products, and electrical devices. Thus, conventionally, barrier layers have been included on or within the packaging associated with the sensitive goods to prevent or limit the permeation of gases or liquids, such as oxygen and water, through the packaging during manufacturing, storage, or use of the goods.

Atomic layer deposition (ALD) is a thin film deposition process described in U.S. Patent Application Publication No. US 2007/0224348 A1 of Dickey et al. ("the '348 publication"), filed March 26, 2007 as U.S. Application No. 11/691,421 and entitled Atomic Layer Deposition System and Method for Coating Flexible Substrates, and in US 2010/0189900 A1 of Dickey et al. ("the '900 publication"), filed April 6, 2010 as U.S. Application No. 12/755,239 and entitled Atomic Layer Deposition System And Method Utilizing Multiple Precursor Zones for Coating Flexible Substrates. Thin film deposition in accordance with the methods and systems disclosed in the '348 and '900 publications have been proposed for deposition of barrier layers on flexible substrates for packaging for sensitive goods and other uses.

Complex multilayer barrier layers including five or six pairs of alternating organic and inorganic layers have been used to prevent the permeation of oxygen and water through plastic substrates of organic light emitting diodes (OLEDs). Some such barriers are so-called nanolaminates made by ALD, having individual layer thicknesses under 10 nanometers (nm). However, multilayer barriers result in a relatively high overall barrier thickness that is not ideal for thin film flexible packaging. Additionally, although some such barriers may exhibit a good short-term water vapor transmission rate (WVTR), many known multilayer barriers have been found to simply have long lag times for vapor transmission rather than significantly reducing steady state permeability.

Aluminum oxide (Al₂O₃, also known as alumina) is a material which decomposes when exposed to high humidity / high temperature environments, making it a risky choice as a moisture barrier film. It also suffers from the lag time problem mentioned above, even for single sided coatings, making quality verification difficult and raising concerns about long term performance for thick Al₂O₃ coatings in high humidity environments. On the other hand, the present inventor has recognized that titanium dioxide (TiO₂, also known as titania) formed using an oxygen-containing plasma makes an excellent water vapor barrier, as disclosed in U.S. Patent Application No. 12/632,749, filed December 7, 2009 and published as US 2010/0143710 A1 ("the '710 publication"). TiO₂ is stable in high humidity environments, and has no single-sided lag time issue. However, the present inventor has found that TiO₂ has a high refractive index, which can lead to optical transmission loss due to reflection, particularly as the required TiO₂ film thickness increases.

Conventional wisdom holds that nanolaminates make better barrier films than mixed materials. See, for example, U.S. Patent No. 4,486,487 disclosing aluminum-titanium-oxide nanolaminates with Al₂O₃ and TiO₂ layers. And many researchers are investigating nanolaminates as a way to improve barrier performance.

US 2009/108747 A1 discloses an organic electroluminescent display including an organic material, a gas barrier layer on the member and an organic electroluminescent unit on the gas barrier layer. US 2010/255625 A1 discloses an apparatus and method for atomic layer deposition on a surface of a substrate.

A need remains for barrier films having very low steady-state vapor permeability and improved optical transmission.

### Brief Description of the Drawings

FIG. 1 is a graph illustrating WVTR as a function of film thickness for mixed AITiO films according to Example 1 discussed below, and comparing to TiO₂ films prepared under similar deposition conditions;
FIG. 2 compares WVTR for the same mixed and TiO₂ films as a function of the number of deposition cycles;
FIG. 3 is a schematic cross-section illustration of a substrate with a single mixed AITiO film deposited thereon;
FIG. 4 is a schematic cross-section illustration of a substrate with mixed AITiO films deposited on both sides; and
FIG. 5 is a schematic cross-section view illustrating a system for thin film deposition on a flexible web configured in a band loop.

### Detailed Description of Preferred Embodiments

The present invention is as set out in the claims. In accordance with the present disclosure, a barrier film comprises a mixture of different metal oxides deposited on a substrate. In contrast to many prior methods of forming multi-layer barriers, *mixtures* according to the present disclosure may have no detectably distinct layers (*i.e.,* essentially a homogenous mixture), or may have alternating layers of different metal oxides that are each less than approximately 1.5 nm thick or, more preferably, less than approximately 1.0 nm thick, or even more preferably less than approximately 0.5 nm thick, or in some cases less than approximately 0.3 nm thick. In some aspects of the present disclosure, mixed films are formed by no more than 15 consecutive deposition cycles of a first metal oxide material before switching to the second metal oxide. In other aspects of the present disclosure, no more than about 2 or 3 molecular layers of a first metal oxide are formed until approximately 10 angstroms (Å) (approximately 1 nm) of the first metal oxide material is deposited, before switching to and depositing a second metal oxide material to a similar thickness, and so on until the desired total thickness of the mixed oxide film is achieved. Such mixtures may consist of tens, hundreds, or thousands of such alternating molecular layers of multiple metal oxides, depending on the desired thickness.

Mixtures according to aspects of the present disclosure may be formed by ALD using precursors from different chemical families for the two metals, and oxygen radicals, such as an oxygen-containing plasma, as the oxygen source. More specifically, in various aspects of the present disclosure, one metal precursor is from a halide family (*e.g.,* chloride or bromide), and another is from a metalorganic family (*e.g.,* alkyl). For example, in one aspect of the present disclosure a mixture of titania and alumina (hereinafter an AITiO) is deposited by ALD using a halide such as titanium tetrachloride (TiCl₄) as the titanium precursor, an alkyl such as trimethylaluminum (TMA) as the aluminum precursor, and a DC plasma formed of dry air as the oxygen precursor for both metal oxides. The oxygen radical-containing plasma preferably contacts the substrate directly (a direct plasma). Mixed AITiO films formed according to the present disclosure have been observed to have a stable WVTR performance for a given film thickness that is far superior to what is observed for either TiO₂ or Al₂O₃ alone, or for so-called "nanolaminates" of the two materials having individual layer thicknesses exceeding 1.5 nm, as illustrated by the examples below. Mixed AITiO films may also have a refractive index that is significantly lower than TiO₂ alone. In some aspects of the present disclosure, such mixed AITiO barrier films have an overall thickness in the range of approximately 2 nm to 10 nm.

Mixed metal oxide films made by ALD using oxygen plasma have been found to exhibit properties that are superior to multi-layer or mixed films made by conventional thermal ALD processes, such as when water is used as the oxygen precursor and the reactor and substrate temperature are heated to 100°C or greater during deposition. For example, in one thermal ALD experiment, a mixed AITiO film having a 1:1 mixture ratio of alumina to titania (mole ratio) was deposited in a Planar Systems P400 batch reactor at 100°C substrate temperature by alternating ALD cycles of the two metal oxides 40 times - *i.e.,* by (a) exposing the substrate to TiCl₄ precursor, (b) exposing it to water vapor, (c) exposing it to TMA, (d) exposing it to water vapor, and repeating steps (a)-(d) forty times. This process is represented by the formulaic notation: 40^{∗}(1^{∗}TiO₂ + 1^{∗}Al₂O₃). Such a 40-cycle mixed TiO₂/Al₂O₃ film made by thermal ALD had an overall thickness of 6.2 nm and exhibited poor (high) WVTR of approximately 0.5 g/m²/day. This is worse than either TiO₂ or Al₂O₃ films alone when made to the same thickness by thermal ALD processing at the same temperature, and also much worse than either individual material, or mixed material produced in an equivalent run using a plasma-based process.

Also, some attempts to form barriers of nanolaminate stacks of TiO₂ and Al₂O₃ using oxygen-containing plasma have not yielded good results. For example, attempts to make simple film stacks such as (5 nm TiO₂ + 5 nm Al₂O₃ + 5 nm TiO₂), or (2 nm TiO₂+ 2 nm Al₂O₃ + 2 nm TiO₂) resulted in films that behaved essentially like an average of the TiO₂ and Al₂O₃ materials, with WVTR generally in between the performance of the two materials, or in some cases worse than either material.

In comparison, films comprising an AITiO *mixture* made using oxygen-containing plasma at less than 100°C exhibit:
1) Stable long term barrier performance in WVTR (unlike Al₂O₃ alone);
2) A refractive index of less than approximately 2.0 (and typically in the range of approximately 1.8 to 1.9), which may result in negligible or minimum reflective loss on flexible polymer films such as PET, BOPP and acrylics for coatings up to 10 to 20 nm (and significantly better than pure TiO₂); and
3) A 30% to 70% reduction in required thickness (and therefore required number of cycles) compared with either Al₂O₃ or TiO₂ alone, or for nanolaminates of those materials with individual layers significantly greater than 1 nm, for a given WVTR performance.

In addition to reducing the number of deposition cycles required to achieve good WVTR and improved optical qualities, thinner films are more flexible and less susceptible to damage upon bending of coated flexible substrates.

Embodiments of a film comprising an AITiO mixture made using an oxygen-containing plasma may exhibit WVTR less than 5 x 10⁻⁴g/m²/day at a thickness of less than about 6 or 8 nm, for example films having a thickness of about 4 or 5 nm. Other embodiments of mixed AITiO films having a thickness of less than approximately 3 or 4 nm may exhibit WVTR of less than 0.005 g/m²/day. Although current test instruments are not sensitive enough to verify it, the present inventors expect that mixed AITiO films having a thickness of less than approximately 8 or 10 nm will have a WVTR of less than 5 x 10⁻⁶ g/m²/day.

For purposes of the present disclosure and claims, WVTR is determined in accordance with ASTM F1249-06(2011) "Standard Test Method for Water Vapor Transmission Rate Through Plastic Film and Sheeting Using a Modulated Infrared Sensor" at 38°C (+/- 0.1°C) and 90%RH, but with a test instrument configured with a coulometric sensor including electrodes coated with phosphorous pentoxide (P₂O₅) rather than a modulated infra-red sensor. In the experimental results set forth below, the WVTR measurements were made either using a MOCON Aquatran® WVTR measurement instrument (indicated as Instrument "MOC") or an Illinois Instruments Model 7001 WVTR test system (indicated as Instrument "II"). Both the MOCON Aquatran and Illinois Instruments 7001 test systems implement ASTM F1249 with a coulometric sensor including electrodes coated with P₂O₅ for improved sensitivity over an infra-red sensor. The MOCON Aquatran instrument has a reliable lower measurement limit of approximately 5 x 10⁻⁴g/m²/day, whereas test instruments implementing an infra-red sensor typically have a lower limit of approximately 5 x 10⁻² g/m²/day. Other available test method specifications include DIN EN ISO 15106-3 (2005). It is possible that over time improved test methods, sensors, and instruments will be developed or discovered to provide improved sensitivity, with lower limits down to 5 x 10⁻⁶g/m²/day or lower, and improved accuracy; and that recognized standards will be adopted for such improved test methods. To the extent that future test methods, sensors, instruments, and standards provide improvements in sensitivity and accuracy over the test methods used to gather WVTR data disclosed herein, they may be used to determine WVTR under the claims.

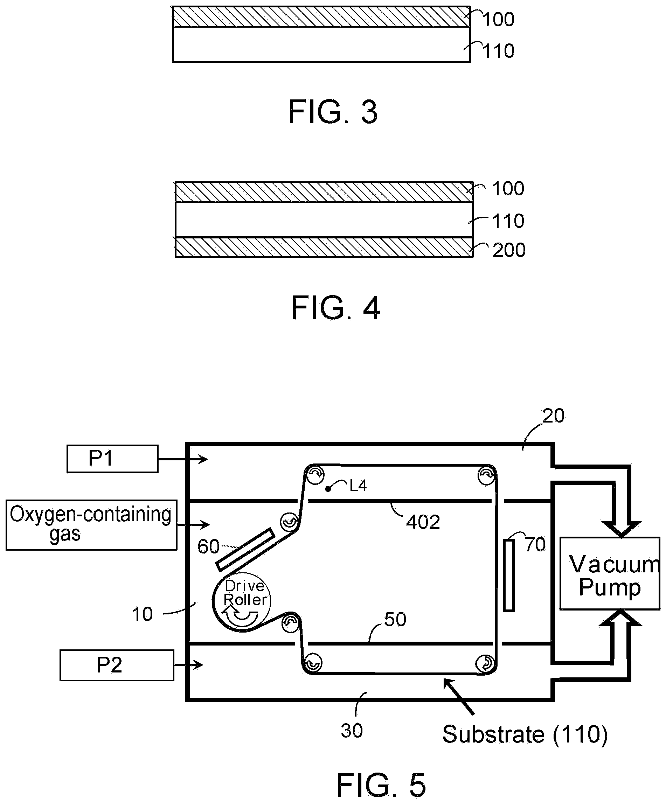

Mixed films according to the present disclosure can be made by the roll-to-roll deposition system disclosed in the '348 publication, using a halide such as TiCl₄ in a first precursor zone, a metalorganic such as TMA in a second precursor zone, and placing an oxygen radical generator in the isolation zone (for example a direct DC plasma generator). In one aspect of the present disclosure, a DC plasma generator is used to energize an oxygen-containing gas (for example dry air, oxygen gas (O₂), carbon dioxide(CO₂), or mixtures of two or more of the foregoing, with or without added nitrogen (N₂) carrier gas) flowing through the isolation zone at a pressure slightly higher than the first and second precursor zones. In another aspect of the present disclosure, a stacked reactor configuration may utilize a multi-zone stack, such as the 5-zone stack illustrated in FIG. 5 of the '900 publication, wherein a halide such as TiCl₄ is introduced in the top and bottom precursor zones and a metalorganic such as TMA is introduced in middle precursor zone, or vice versa, and oxygen radicals are generated from oxygen-containing gas introduced in the intermediate isolation zones separating the TiCl₄ and TMA zones.

The deposition process, including growth rate and barrier properties, are relatively insensitive to substrate temperature, at least in the range of about 50°C to 100°C, which facilitates the use of flexible polymer film substrates such as bi-axially oriented polypropylene (BOPP), which cannot withstand temperatures greater than about 70°C.

It is expected that mixed metal oxide films in accordance with the present disclosure will have barrier properties (WVTR, oxygen transmission, etc.) that are more stable than Al₂O₃ and many other single metal oxide barriers. For example, upon exposure to test conditions of 38°C and 90%RH for a time period in the range of 24 hours, 48 hours, or up to one week, mixed AITiO films deposited on a flexible polymer substrate are expected to exhibit an increase (or change) in WVTR of less than 50% over initial settled readings. In another prophetic example, upon exposure to test conditions of 38°C and 90%RH for a time period in the range of two weeks and 30 days, mixed AITiO barrier films deposited on a flexible polymer substrate are expected to exhibit an increase in WVTR of less than 100% over initial settled readings.

FIG. 3 illustrates a cross section of a single thin film barrier layer of mixed AITiO 100 deposited on a flexible substrate 110 (also referred to as a single-sided barrier layer). FIG. 4 illustrates a cross section of first and second thin film barrier layers 100 and 200 of mixed AITiO deposited on opposite sides of a flexible substrate 110 (also referred to as a double-sided barrier).

FIG. 5 provides a schematic illustration of a prototype roll-to-roll deposition system used to perform tests of Examples 1 and 4, below. This system is consistent with the systems described in the '348 publication and especially with the system of FIG. 5 of the '710 publication. With reference to FIG. 5 herein, a "loop-mode" configuration wraps a substrate 110 into an endless band (loop), which includes a single path that performs two ALD cycles on each revolution as the substrate moves from the central isolation zone 10, into the first precursor zone 20, back to the isolation zone 10, to the second precursor zone 30, and to finish back in the isolation zone 10. As the substrate web 110 travels between zones 10, 20, 30 it passes through slit valves, which are just slots in divider plates 40, 50 that separate the different zones. In this configuration the substrate web 110 can be passed repeatedly through the precursor and isolation zones (10→20→10→30) in a closed loop. (This system is referred to herein as a "roll-to-roll" deposition system, even though the loop substrate configuration used for experimental purposes does not involve transporting the substrate from a feed roll to an uptake roll.) In the loop configuration illustrated in FIG. 5, a full traverse of the loop path results in two ALD deposition cycles when two plasma generators 60, 70 are employed in isolation zone 10. The substrate band is circulated along this loop path x number of times to attain 2x ALD cycles - half of the first precursor and half of the second precursor (expressed as: x^{∗}(1^{∗}TiO₂ + 1^{∗}A₂O₃) herein). A modified version of the system of FIG. 5 herein was utilized to generate test samples according to Examples 2, 3, and 5, as described below, in some cases performing only a single ALD cycle on each revolution of the substrate.

### EXAMPLE 1

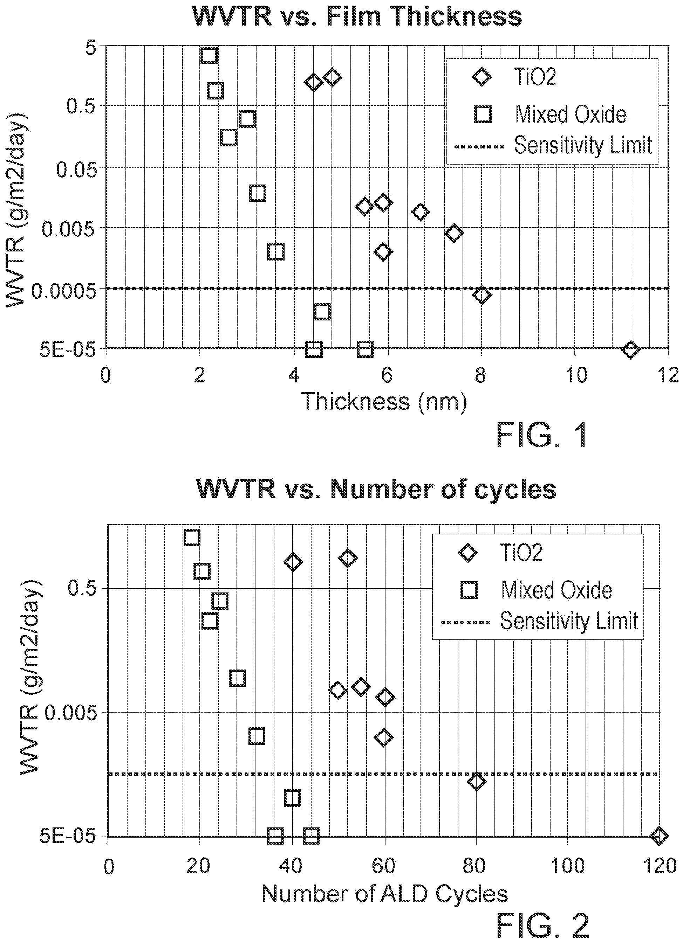

Films of varied thicknesses mixed in a 1:1 cycle ratio (x^{∗}(1^{∗}TiO₂ + 1^{∗}Al₂O₃)) were deposited on a substrate of DuPont Tejin Mellinex® ST-504 in experimental runs at 80°C using a deposition system having band loop configuration according to FIG. 5, using a dry air plasma, and transporting the substrate at 30 meters/minute (m/min). At this transport speed, the substrate was exposed to TMA precursor for approximately 1 second, to the oxygen plasma for approximately 0.25 second, and to TiCl₄ precursor for approximately 1 second, and again to the oxygen plasma for approximately 0.25 second, and then the sequence repeated. The minimum film thickness showing any barrier properties was approximately 2 nm thick achieved by 9 pairs of deposition cycles, denoted as: (9^{∗}(1^{∗}TiO₂ + 1^{∗}Al₂O₃)). For 12 pairs (24 total cycles), yielding a total film thickness of approximately 3 nm, the WVTR was approximately 0.03 g/m²/day, which is good enough for commercial food packaging. For 20 pairs (40 total cycles), yielding approximately 5 nm total film thickness, WVTR was below the reliable detection limit of the MOCON Aquatran system (< ∼5 x 10⁻⁴ g/m²/day). Thus, the slope of the curve of WVTR vs. thickness was very steep. In comparison, approximately 3.0 to 3.5 nm of either Al₂O₃ or TiO₂ alone is required before any barrier properties are observed, *i.e.,* before any improvement in WVTR is observed over the WVTR of a bare uncoated substrate. TiO₂ film must have a thickness of approximately 8-10 nm or more to reliably reach the Aquatran detection limit, and Al₂O₃ film must have a thickness of greater than about 20 nm to exhibit WVTR below the Aquatran detection limit. FIG. 1 is a graph illustrating WVTR as a function of film thickness for 1:1 ratio mixed films according to this example, and for TiO₂-only films prepared under like deposition conditions. FIG. 2 compares WVTR for the same mixed AITiO and TiO₂ films as a function of the number of deposition cycles. The experimental data used to generate the graphs of FIGS. 1 and 2 is set forth below in Tables 1 and 2, below.

**TABLE 1: Mixed AITiO**

| **# Cycles** | **Thickness** | **WVTR** | **Instrument** |
|---|---|---|---|
| 18 | 2.2 | 3.3 | II |
| 20 | 2.3 | 0.90 | II |
| 22 | 2.6 | 0.15 | II |
| 24 | 3.0 | 0.30 | II |
| 28 | 3.2 | 0.018 | II |
| 32 | 3.6 | 0.002 | II |
| 36 | 4.4 | 0.00005 | MOC |
| 40 | 4.6 | 0.0002 | MOC |
| 44 | 5.5 | 0.00005 | MOC |

**TABLE 2: TiO₂**

| **# Cycles** | **Thickness** | **WVTR** | **Instrument** |
|---|---|---|---|
| 120 | 11.2 | 0.00005 | MOC |
| 60 | 5.9 | 0.002 | MOC |
| 80 | 8 | 0.0004 | MOC |
| 52 | 4.8 | 1.5 | II |
| 55 | 5.9 | 0.013 | II |
| 50 | 5.5 | 0.011 | II |
| 60 | 6.7 | 0.009 | II |
| 40 | 4.4 | 1.25 | II |
| 65 | 7.4 | 0.004 | II |

### EXAMPLE 2

Multiple consecutive cycles of each metal were also tested, with the number of consecutive cycles being increased gradually to determine limits for loss of properties. Films made according to the following processes behaved relatively similarly, evidencing a homogenous mixture:
2^{∗}(8^{∗}TiO₂ + 8^{∗}Al₂O₃)
4^{∗}(4^{∗}TiO₂ + 4^{∗}Al₂O₃)
8^{∗}(2^{∗}TiO₂ + 2^{∗}Al₂O₃)

However, a film made by the process 1^{∗}(16^{∗}TiO₂+16^{∗}Al₂O₃) produced inferior results, and in this film the Al₂O₃ stability problem mentioned above was evident.

In the experiments of this Example 2, a modified configuration of the experimental reactor shown in FIG. 5 was used. In the modified configuration, precursor inlets for both TiCl₄ and TMA were plumbed to the top precursor zone 20, each with a shut-off valve, and the plasma generator was located in the bottom precursor zone 30, into which the oxygen-containing precursor was injected. An inert gas was injected into the isolation zone 10. One of the two valves was opened to introduce a first precursor for multiple revolutions of the band loop, then that valve closed and top precursor zone purged with inert gas before opening the other valve for multiple cycles using the second precursor, and the process repeated as needed.

### EXAMPLE 3

Mixtures of TiO₂/Al₂O₃ having a 1:3 and 3:1 mole ratio, *i.e.,* n^{∗}(1^{∗}TiO₂ + 3^{∗}Al₂O₃) and n^{∗}(3^{∗}TiO₂ + 1^{∗}Al₂O₃), were produced according to the valve-controlled reactor procedure described in Example 2, above, and their WVTR was tested. For films of comparable thickness, the TiO₂-rich film showed good barrier performance (low WVTR), similar to 1:1 ratio films, but the Al₂O₃-rich mixture exhibited the long term stability problem described above and an ultimate WVTR that was much higher than 1:1 ratio AITiO films or the 3:1 ratio TiO₂-rich film.

### EXAMPLE 4

The test process applied in Example 4 was essentially the same process as in Example 1, except substrate transport speed was reduced to approximately 15 meters/min (half of the speed of Example 1, resulting in precursor and plasma exposure times being roughly doubled). Other conditions include: 65°C substrate temperature, dry air plasma at pressure of approximately 1.4 Torr, operating in "REALD" configuration described in the '710 publication with reference to FIG. 5 thereof - band loop mode with TMA in top zone, TiCl4 in bottom zone, and two plasma electrodes 60, 70 (FIG. 6) in the center isolation zone, each electrode approximately 50 cm wide by 60 cm long, total plasma power of approximately 140W DC distributed between the two electrodes.

At the reduced transport speed of 15 m/min, the growth rate for a single pair of cycles (1^{∗}TiO₂ + 1^{∗}Al₂O₃) increased to approximately 0.3 to 0.33 nm per pair, indicating that underdosing was occurring at 30 m/min. Surface saturation was achieved at around 15 m/min, and the growth rate was not observed to increase at speeds below 15 m/min. Interestingly, the thin film growth rate at a substrate speed of 15 m/min is higher than expected from average of steady state deposition of Al₂O₃ or TiO₂ films (0.16 nm for Al2O3 and 0.10 nm for TiO2 - for a total of 0.26 nm per pair). The critical required thickness for onset of any barrier properties does not change, remaining at about 2 nm. However, perhaps partly because growth rate per cycle is increased, WVTR of less than 5 x 10⁻⁴ g/m²/day can be achieved for cycle counts as low as 2^{∗}15 pairs, or 30 total cycles, as compared with 2^{∗}18 pairs (36 total cycles) under the conditions of Example 1.

### EXAMPLE 5

In another test, mixed AITiO films were deposited in a three-step process, whereby the substrate was exposed to dry air plasma only after one of the two metal precursors (*e.g*., TMA → plasma → TiCl₄ →TMA→plasma→TiCl₄ - etc.). In other words, one of the plasma generators 60, 70 of the band loop system of FIG. 6 was deactivated. Surprisingly, films deposited by such a 3-step process did not just behave like those made by a process for forming only one of the two metal oxide films (e.g. Al₂O₃ alone). Data concerning these 3-step processes is set forth in Tables 3A and 3B below:

**TABLES 3A and 3B:**

| 3-step: TiCl4 + Plasma + TMA | | | | | |
|---|---|---|---|---|---|
| | **Run#** | **#Pairs** | **Thickness** | **WVTR** | **Inst** |
| | 633 | 18 | 39 | 0.027 | II |
| | | | | | |

| 3-step: TMA + Plasma + TiCl4 | | | | | |
|---|---|---|---|---|---|
| | **Run#** | **#Pairs** | **Thickness** | **WVTR** | **Inst** |
| | 634 | 18 | 43 | 0.004 | II |

Notably, the growth rate for each the above 3-step sequences was greater than for either of TiO₂ or Al₂O₃ alone, suggesting TMA and TiCl₄ may be reacting directly, and indicating unique chemistry related to the sequential exposure to a halide and the metal alkyl. The 3-step "TMA+Plasma+TiCl4" sequence yields about the same growth rate as a full pair of oxides in a 4-step sequence whereby the substrate is exposed to plasma after each metal precursor (*e.g.,* TMA + Plasma + TiCl₄ + plasma), and still has much better barrier properties than either individual oxide alone. For example, the barrier properties yielded by the 3-step process "TMA+Plasma+TiCl4" are nearly as good as the properties resulting from the 4-step process.

## Claims

1. A method of depositing a barrier layer onto a substrate, comprising:
while maintaining the surface temperature of the substrate at less than 100°C, repeating the following sequence of steps multiple times until a film comprising an alumina and titania mixture, having a thickness of at least 2 nm, and a water vapor transmission rate of 5 x 10⁻⁴g/m²/day or less, is formed on the substrate:
(a) exposing the substrate to one of a halide as the titanium precursor or a metalorganic as the aluminum precursor;
(b) after step (a), exposing the substrate to an oxygen plasma; and
(c) exposing the substrate to the other of the halide and the metalorganic wherein the ratio of the number of times step (a) is performed to the number of times step (c) is performed is between 1:1 and 3:1, and in which step (a) is exposing the substrate to the halide.

2. The method of claim 1, in which the sequence of steps further comprises after step (c): (d) exposing the substrate to an oxygen plasma.

3. The method of claim 1, in a sub-sequence of steps (a) and (b) is repeated multiple times before performing step (c).

4. The method of claim 1, in which the halide is a titanium halide and the metalorganic is an organoaluminum.

5. The method of claim 1, further comprising:
introducing gaseous halide in a first precursor zone;
introducing gaseous metal organic in a second precursor zone spaced apart from the first precursor zone;
introducing an oxygen-containing gas into an isolation zone interposed between the first and second precursor zones so as to create a pressure in the isolation zone that is slightly higher than pressures in the first and second precursor zone;
imparting relative movement between the substrate and the precursor zones; and
energizing the oxygen-containing gas in the isolation zone in proximity to the substrate so as to generate the oxygen plasma.

6. The method of claim 5, wherein the substrate is transported back and forth between the first and second precursor zones multiple times, and each time through the isolation zone.

7. The method of claim 1, wherein the step (b) includes exposing the substrate to the oxygen plasma for at least 0.25 second.

8. The method of claim 1, wherein the film has a refractive index less than 2.0.

9. The method of claim 1, wherein the substrate is a flexible biaxially-oriented polypropylene film.

10. The method of any preceding claim, wherein the titanium halide is titanium tetrachloride and the organoaluminum is trimethylaluminum.

11. A barrier layer deposited onto a flexible polymer substrate, the barrier layer having an overall thickness of at least 2 nm to less than 10 nm and comprising a homogeneous alumina and titania mixture ("AITiO mixture"), wherein the barrier layer has an alumina to titania ratio in the range of 1:1 to 1:3, the barrier layer having a water vapor transmission rate ("WVTR") of less than 5 x 10⁻⁴g/m²/day when the barrier layer has an overall thickness of less than 8 nm or a WVTR of less than 0.005 g/m²/day when the barrier layer has an overall thickness of less than 4 nm.

12. A barrier layer according to claim 11, wherein the overall thickness is less than 8 nm; OR wherein the overall thickness is less than 6 nm.

13. A barrier layer according to any one of claims 11 or 12, in which a refractive index of the barrier layer is less than 2.0.

14. A barrier layer according to any one of claims 11 or 12, wherein the AITiO mixture within the barrier layer has no detectably distinct layers.

15. A barrier layer according to any one of claims 11 to 14, wherein the barrier layer is formed using an oxygen plasma while the surface temperature of the flexible polymer substrate is less than 100°C.

16. A barrier layer deposited onto a substrate, wherein the barrier layer is obtainable by the method of any one of claims 1 to 10.

## Patentansprüche

1. Verfahren zur Abscheidung einer Barriereschicht auf ein Substrat, umfassend: während Beibehaltung der Oberflächentemperatur auf weniger als 100°C, Wiederholen der folgenden Reihenfolge von Schritten mehrere Male, bis ein Film, der eine Mischung aus Aluminiumoxid und Titan umfasst, eine Dicke von zumindest 2 nm und eine Wasserdampfdurchlässigkeitsrate von 5 x 10⁻⁴g/m²/Tag oder weniger aufweist, auf dem Substrat geformt ist:
(a) Aussetzen des Substrats einem von einem Halogenid als den Titan-Vorläufer oder einer metallorganischen Verbindung als den Aluminium-Vorläufer;
(b) nach Schritt (a), Aussetzen des Substrats einem Sauerstoffplasma; und
(c) Aussetzen des Substrats dem anderen des Halogenids und der metallorganischen Verbindung, wobei das Verhältnis der Male, die der Schritt (a) durchgeführt wird zum Male, die der Schritt (c) durchgeführt wird zwischen 1:1 und 3:1 liegt, und wobei der Schritt (a) das Substrat dem Halogenid aussetzt.

2. Verfahren nach Anspruch 1, wobei die Reihenfolge von Schritten ferner nach Schritt (c) umfasst: (d) Aussetzen des Substrats einem Sauerstoffplasma;

3. Verfahren nach Anspruch 1 wird, in einer untergeordneten Reihenfolge von Schritten (a) und (b) viele Male vor der Durchführung von Schritt (c) wiederholt.

4. Verfahren nach Anspruch 1, wobei das Halogenid ein Titanhalogenid ist und die metallorganische Verbindung ein Organoaluminum ist.

5. Verfahren nach Anspruch 1, ferner umfassend:
Einführen von gasförmigem Halogenid in eine erste Vorläuferzone;
Einführen von gasförmiger metallorganischer Verbindung in eine zweite Vorläuferzone beabstandet von der ersten Vorläuferzone;
Einführen eines sauerstoffhaltigen Gases in eine Isolationszone zwischen die ersten und zweiten Vorläuferzonen, um einen Druck in der Isolationszone zu schaffen, der geringfügig höher als Drücke in den ersten und zweiten Vorläuferzonen ist;
Vermitteln relativer Bewegung zwischen dem Substrat und den Vorläufer-Zonen; und
Aktivieren des sauerstoffhaltigen Gases in der Isolationszone in Nähe des Substrats, um Sauerstoffplasma zu generieren.

6. Verfahren nach Anspruch 5, wobei das Substrat viele Male zwischen den ersten und zweiten Vorläuferzonen hin und her und jedes Mal durch die Isolationszone transportiert wird.

7. Verfahren nach Anspruch 1, wobei der Schritt (b) einschließt, das Substrat dem Sauerstoffplasma für zumindest 0,25 Sekunden auszusetzen.

8. Verfahren nach Anspruch 1, wobei der Film einen Brechungsindex von weniger als 2,0 aufweist.

9. Verfahren nach Anspruch 1, wobei das Substrat ein flexibler biaxial orientierter Polypropylenfilm ist.

10. Verfahren nach einem vorhergehenden Anspruch, wobei das Titanhalogenid Titantetrachlorid ist und das Organoaluminium Trimethylaluminium ist.

11. Barriereschicht abgeschieden auf ein flexibles Polymersubstrat, wobei die Barriereschicht eine Gesamtdicke von zumindest 2 nm bis weniger als 10 nm aufweist und eine homogene Mischung aus Aluminiumoxid und Titandioxid ("AlTiO-Mischung") umfasst, wobei die Barriereschicht ein Verhältnis von Aluminiumoxid zu Titandioxid im Bereich von 1:1 bis1:3 aufweist, die Barriereschicht eine Wasserdampfdurchlässigkeitsrate ("WVTR") von weniger als 5 x 10⁻⁴g/m²/Tag aufweist, wenn die Barriereschicht eine Gesamtdicke von weniger als 8 nm oder eine WVTR von weniger als 0,005 g/m²/Tag aufweist, wenn die Barriereschicht eine Gesamtdicke von weniger als 4 nm aufweist.

12. Barriereschicht nach Anspruch 11, wobei die Gesamtdicke weniger als 8 nm beträgt ODER wobei die Gesamtdicke weniger als 6 nm beträgt.

13. Barriereschicht nach einem der Ansprüche 11 oder 12, wobei ein Brechungsindex der Barriereschicht weniger als 2,0 ist.

14. Barriereschicht nach einem der Ansprüche 11 oder 12, wobei die AITiO-Mischung innerhalb der Barriereschicht keine erkennbaren deutlichen Schichten aufweist.

15. Barriereschicht nach einem der Ansprüche 11 bis 14, wobei die Barriereschicht unter Verwendung eines Sauerstoffplasmas während die Oberflächentemperatur des flexiblen Polymersubstrats weniger als 100°C beträgt.

16. Barriereschicht ausgeschieden auf ein Substrat, wobei die Barriereschicht durch das Verfahren nach einem der Ansprüche 1 bis 10 erhältlich ist.

## Revendications

1. Procédé permettant de déposer un film barrière sur un substrat, consistant à :
tout en maintenant la température de surface du substrat inférieure à 100°C, répéter la séquence d'étapes suivante plusieurs fois jusqu'à ce qu'un film comprenant un mélange d'alumine et de dioxyde de titane, ayant une épaisseur d'au moins 2 nm et une vitesse de transmission de la vapeur d'eau égale ou inférieure à 5 x 10⁻⁴g/m²/jour, soit formé sur le substrat :
(a) exposer le substrat à soit un halogénure étant le précurseur de titane, soit un organométallique étant le précurseur d'aluminium ;
(b) après l'étape (a), exposer le substrat à un plasma d'oxygène ; et
(c) exposer le substrat à l'autre de soit l'halogénure, soit l'organométallique
dans lequel le rapport du nombre de fois où l'étape (a) est effectuée au
nombre de fois où l'étape (c) est effectuée est compris entre 1:1 et 3:1, et
dans lequel l'étape (a) expose le substrat à l'halogénure.

2. Procédé selon la revendication 1, dans lequel la séquence d'étapes consiste en outre à après l'étape (c) : (d) exposer le substrat à un plasma d'oxygène.

3. Procédé selon la revendication 1, dans lequel une sous-séquence des étapes (a) et (b) est répétée plusieurs fois avant d'effectuer l'étape (c).

4. Procédé selon la revendication 1, dans lequel l'halogénure est un halogénure de titane et l'organométallique est un organoaluminium.

5. Procédé selon la revendication 1, consistant en outre à :
introduire un halogénure gazeux dans une première zone de précurseur ;
introduire un organométallique gazeux dans une deuxième zone de précurseur à distance de la première zone de précurseur ;
introduire un gaz contenant de l'oxygène dans une zone d'isolation intercalée entre les première et deuxième zones de précurseur de façon à créer une pression dans la zone d'isolation qui est légèrement supérieure aux pressions dans les première et deuxième zones de précurseur ;
conférer un mouvement relatif entre le substrat et les zones de précurseur ; et
exciter le gaz contenant de l'oxygène dans la zone d'isolation à proximité du substrat de façon à générer le plasma d'oxygène.

6. Procédé selon la revendication 5, dans lequel le substrat est transporté en va-et-vient entre les première et deuxième zones de précurseur plusieurs fois, et chaque fois à travers la zone d'isolation.

7. Procédé selon la revendication 1, dans lequel l'étape (b) consiste à exposer le substrat au plasma d'oxygène pendant au moins 0,25 seconde.

8. Procédé selon la revendication 1, dans lequel le film a un indice de réfraction inférieur à 2,0.

9. Procédé selon la revendication 1, dans lequel le substrat est un film de polypropylène à orientation biaxiale flexible.

10. Procédé selon l'une quelconque des revendications précédentes, dans lequel l'halogénure de titane est un tétrachlorure de titane et l'organoaluminium est un triméthylaluminium.

11. Film barrière déposé sur un substrat polymère flexible, le film barrière ayant une épaisseur totale égale ou supérieure à 2 nm à inférieure à 10 nm et comprenant un mélange d'aluminium, de dioxyde de titane homogène (mélange "AlTiO"), dans lequel le film barrière a un rapport de l'alumine au dioxyde de titane compris entre 1:1 et 1:3, le film barrière ayant une vitesse de transmission de la vapeur d'eau ("WVTR") inférieure à 5 x 10⁻⁴ g/m²/jour quand le film barrière a une épaisseur totale inférieure à 8 nm ou une vitesse WVTR inférieure à 0,005 g/m²/jour quand le film barrière a une épaisseur totale inférieure à 4 nm.

12. Film barrière selon la revendication 11, dans lequel l'épaisseur totale est inférieure à 8 nm ; OU dans lequel l'épaisseur totale est inférieure à 6 nm.

13. Film barrière selon l'une quelconque des revendications 11 ou 12, dans lequel un indice de réfraction du film barrière est inférieure à 2,0.

14. Film barrière selon l'une quelconque des revendications 11 ou 12, dans lequel le mélange AITiO dans le film barrière n'a pas de couches distinctes détectables.

15. Film barrière selon l'une quelconque des revendications 11 à 14, dans lequel le film barrière est formé en utilisant un plasma d'oxygène pendant que la température de surface du substrat polymère flexible est inférieure à 100°C.

16. Film barrière déposé sur un substrat, dans lequel le film barrière peut être obtenu par le procédé selon l'une quelconque des revendications 1 à 10.
